# EUROPÄISCHE PATENTANMELDUNG

(11) **EP 0 877 387 A2**
(43) Veröffentlichungstag der Anmeldung: **11.11.1998**
(21) Anmeldenummer: 98201369.0
(22) Anmeldetag: 28.04.1998
(51) Int. Cl.: G11C 27/04

(54) **Verzögerungsanordnung**

(30) Priorität: 02.05.1997 DE 19718617
(71) Anmelder: Philips Patentverwaltung GmbH, 22335 Hamburg (DE); Koninklijke Philips Electronics N.V., 5621 BA Eindhoven (NL)
(72) Erfinder: Struck, Sönke, c/o Philips Patentverwaltung GmbH, 22335 Hamburg (DE); Ernst, Holger, c/o Philips Patentverwaltung GmbH, 22335 Hamburg (DE)
(74) Vertreter: von Laue, Hanns-Ulrich, Dipl.-Ing.

(57) **Zusammenfassung**

Es wird eine Verzögerungsanordnung beschrieben, welche Speicherelemente aufweist, welche in einer integrierten Schaltung in wenigstens zwei Reihen 4,5; 6,7, vorzugsweise in Switched-Capacitor-Technik, aufgebaut sind. Dabei weist die Verzögerungsanordnung 2; 3 eine geradzahlige Anzahl von Speicherelementen auf. Es ist ein erstes Taktsignal vorgesehen ist, aus welchem zur Erzeugung einer Verzögerungszeit eines ungeradzahligen Vielfachen der Taktperiode des ersten Taktsignals mittels einer Takterzeugungsanordnung 9 ein zweites Taktsignal generiert wird, mittels welchem die Speicherelemente getaktet werden und welches in der Weise aus dem ersten Taktsignal generiert wird, daß in einem wählbaren oder vorgegebenen Zyklus ein Taktimpuls des ersten Taktsignals unterdrückt wird und alle übrigen Taktimpulse in dem Zyklus in das zweite Taktsignal übernommen werden.

## Beschreibung

Die Erfindung betrifft eine Verzögerungsanordnung, welche Speicherelemente aufweist, welche in einer integrierten Schaltung in wenigstens zwei Reihen, vorzugsweise in Switched-Capacitor-Technik, aufgebaut sind.

Aus der EP-A-0 383 387 ist eine integrierte Schaltung bekannt, welche Verzögerungsanordnungen aufweist, deren Speicherelemente in Switched-Capacitor-Technik aufgebaut sind und die in mehreren Reihen angeordnet sind. Bei derartigen Verzögerungsanordnungen, deren Speicherelemente in mehreren Reihen aufgebaut sind, entsteht dann ein Problem, wenn mittels der Verzögerungsanordnungen eine Verzögerung um ein ungeradzahliges Vielfaches der Taktperiode vorgenommen werden soll, mit der die in den Speicherelementen zwischengespeicherten Signale ausgelesen werden. Es muß nämlich beim Auslesen (wie auch beim Einlasen) der Takt wechselweise den Reihen der Speicherelemente zugeführt werden, wobei in den Reihen jeweils die gleiche Anzahl von Speicherelementen vorgesehen sein muß. Es ist daher beispielsweise bei einer Verzögerungsanordnung, deren Speicherlemente in zwei Reihen angeordnet sind, eine Verzögerung um ein ungeradzahliges Vielfaches des Taktsignals beim Ein- bzw. Auslesen nicht ohne weiteres durchführbar.

Es ist Aufgabe der Erfindung, eine derartige Verzögerungsanordnung anzugeben, bei der dieses Problem überwunden wird.

Diese Aufgabe ist erfindungsgemäß dadurch gelöst, daß die Verzögerungsanordnung eine geradzahlige Anzahl von Speicherelementen aufweist und daß ein erstes Taktsignal vorgesehen ist, aus welchem zur Erzeugung einer Verzögerungszeit eines ungeradzahligen Vielfachen der Taktperiode des ersten Taktsignals mittels einer Takterzeugungsanordnung ein zweites Taktsignal generiert wird, mittels welchem die Speicherelemente getaktet werden und welches in der Weise aus dem ersten Taktsignal generiert wird, daß in einem wählbaren oder vorgegebenen Zyklus ein Taktimpuls des ersten Taktsignals unterdrückt wird und alle übrigen Taktimpulse in dem Zyklus in das zweite Taktsignal übernommen werden.

Bei den Anordnungen nach dem Stande der Technik würde das Ein- und Auslesen quasi mit dem ersten Taktsignal geschehen. Dieses Taktsignal weist eine solche Frequenz auf, daß die Taktperiode die gewünschten Zeitpunkte angibt, zu denen ein- bzw. ausgelesen werden soll. Hierbei tritt jedoch das oben genannte Problem auf. Es wird daher mittels einer Takterzeugungsanordnung ein zweites Taktsignal generiert, welches im wesentlichen mit dem ersten Taktsignal übereinstimmt. Jedoch wird in dem zweiten Taktsignal relativ zum ersten Taktsignal in vorgegebenen Zyklen jeweils ein Impuls unterdrückt. Bei einem solchen Zyklus kann es sich beispielsweise um die Dauer einer Bildzeile eines Fernsehsignals handeln, das mittels der Verzögerungsanordnung verzögert werden soll. Eine solche Zeile hat eine vorgegebene Dauer und seine Dauer entspricht infolgedessen einer bestimmten Zahl von Taktimpulsen des ersten Taktsignals. Diese Zahl von Taktimpulsen markiert in diesem Beispielsfall den vorgegebenen Zyklus. In diesem Zyklus wird aus den Impulsen des ersten Taktsignals jeweils ein Impuls unterdrückt und so das zweite Taktsignal generiert.

Damit sind mittels des zweiten Taktsignals zwei Ziele erreicht worden. Zum einen weist die Taktperiode die gewünschte Zeitdauer auf, d.h. das zweite Taktsignal weist nach wie vor diejenige Taktperiode des ersten Taktsignals auf, mit der die Daten in die Verzögerungsanordnung eingelesen bzw. aus dieser ausgelesen werden. Dennoch weist es in dem vorgegebenen Zyklus eine ungeradzahlige Anzahl von Taktimpulsen auf, so daß es gelingt, innerhalb des wählbaren oder vorgegebenen Zyklus, eine Verzögerungszeit zu erzeugen, welche ein ungeradzahliges Vielfaches der Taktperiode des ersten Taktsignals darstellt.

Gemäß einer Ausgestaltung der Erfindung sind die Merkmale gemäß Anspruch 2 vorgesehen. Der in dem vorgegebenen oder wählbaren Zyklus unterdrückte Taktimpuls bewirkt, daß zu dieser Zeit kein Signal ein- bzw. ausgelesen werden kann. Daher wird dieser Taktimpuls in dem zweiten Taktsignal vorzugsweise so angeordnet, daß er zu Zeiten auftritt, in denen kein Bildinhalt übertragen wird.

Eine weitere vorteilhafte Ausgestaltung der Erfindung ergibt sich aus den Merkmalen des Anspruches 3. In vielen Filteranordnungen, insbesondere auch in Kammfilteranordnungen, werden mehrere, meist zwei, Verzögerungsanordnungen eingesetzt. Für derartige Filteranordnungen ist die Erzeugung des zweiten Taktsignals nur einmal erforderlich. Es muß daher die Takterzeugungsanordnung nur einmal gemeinsam für alle Verzögerungsanordnungen vorgesehen sein.

Beispielsweise für eine Kammfilteranordnung, mittels der das Chroma-Signal eines von einem Videorekorder wiedergegebenen Bildsignals der PAL-Norm gefiltert werden soll, sollen die Verzögerungsanordnungen, wie gemäß Anspruch 5 vorgesehen ist, eine Verzögerung entsprechend einer Dauer von 1135 Taktimpulsen vornehmen, da mit dieser Anzahl eine ideale Kammfilterung erzielt wird. Da dies mit einer geradzahligen Anzahl von Speicherelementen nicht realisierbar ist, wird in diesem Beispielsfall wird aus dem ersten Taktsignal mit einem Zyklus von 1135 Taktimpulsen das zweite Taktsignal in der Weise generiert, daß in dem Zyklus ein Impuls weggelassen wird, so daß das zweite Taktsignal in einem Zyklus gleicher Länge nur noch 1134 Taktimpulse aufweist, welche zum Ein- bzw. Auslesen der Speicherzellen der Verzögerungsanordnungen ideal sind.

Nachfolgend wird ein Ausführungsbeispiel der Erfindung anhand der Zeichnung näher erläutert. Es zeigen:
Fig. 1 ein Blockschaltbild einer Kammfilteranordnung mit zwei Verzögerungsanordnungen und einer Taktimpulserzeugungsanordnung gemäß der Erfindung und
Fig. 2 eine zeitliche ausschnittsweise Darstellung des ersten und zweiten Taktsignals der Anordnung gemäß Fig. 1.

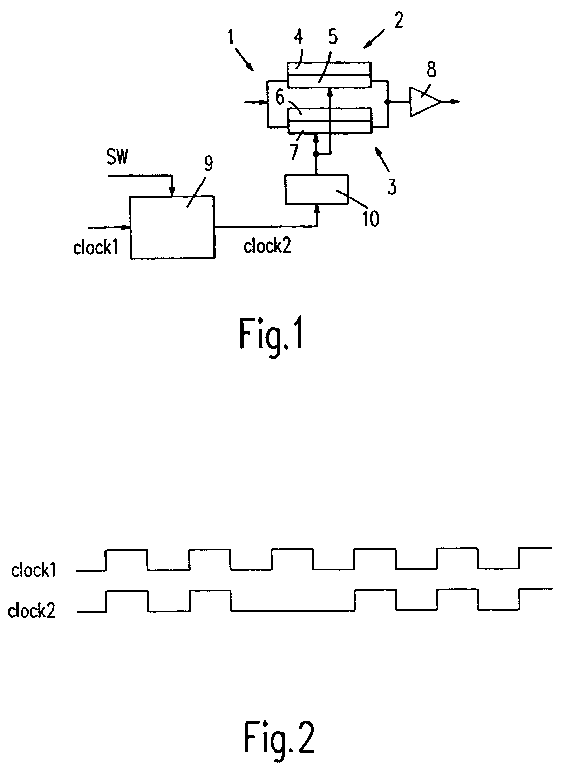

In Fig. 1 ist in Form eines Blockschaltbildes eine Kammfilteranordnung 1 dargestellt, welche zwei Verzögerungsanordnungen 2 und 3 aufweist.

Jede der Verzögerungsanordnungen 2 und 3 weist in der Figur nicht näher dargestellte Speicherlemente auf, welche in zwei Reihen 4 und 5 bzw. 6 und 7 aufgebaut sind. Vorzugsweise sind die Speicherelemente in Switched-Capacitor-Technik realisiert.

Beispielsweise zur Filterung eines von einem Videorekorder wiedergegebenen Bildsignals gemäß der PAL-Übertragungsnorm weisen die Verzögerungsanordnungen 1134 Speicherzellen auf. Zur idealen Filterung des Signals wären jedoch 1135 Speicherzellen günstiger. Da sich diese einerseits nicht realisieren lassen und andererseits die Taktperiode beim Ein- und Auslesen der einzelnen Speicherzellen nicht verändert werden soll, ist eine Takterzeugungsanordnung 9 vorgesehen, welche aus einem ersten Taktsignal, das Taktimpulse mit der gewünschten Taktperiode aufweist, ein zweites Taktsignal generiert. Dieses Taktsignal weist in einem Zyklus nur 1134 Taktimoulse auf und wird mittels einer Taktverarbeitungsschaltung 10 aufbereitet und den beiden Verzögerungsanordnungen 2 und 3 bzw. den in den Reihen 4 und 5 bzw. 6 und 7 angeordneten Speicherzellen zugeführt.

Das Eingangssignal der Kammfilteranordnung, bei dem es sich beispielsweise um ein Bildsignal handeln kann, wird beiden Verzögerungsanordnungen 2 und 3 der Kammfilteranordnung 1 zugeführt. Ausgangsseitig werden die beiden Signale zusammengeführt und mittels eines Verstärkers 8 verstärkt und als Ausgangssignal zur Verfügung gestellt.

Für den oben bereits erwähnten Beispielsfall, daß es sich bei dem der Kammfilteranordnung zugeführten Signal um ein von einem Videorekorder wiedergegebenes Bildsignal der PAL-Norm handelt, weisen die Speicheranordnungen 1134 Speicherzellen auf, die in jeweils den beiden Reihen 4 und 5 bzw. 6 und 7 angeordnet sind. Die Ein- und Auslesevorgänge werden in beiden Verzögerungsanordnungen 2 und 3 verschieden gesteuert, so daß mit der einen Verzögerungsanordnung eine Dauer von etwa zwei Bildzeilen des Bildsignals erzielt wird, wohingegen mit der anderen Verzögerungsanordnung nur eine sehr geringfügige Verzögerungsdauer erzielt wird. Die zweite Verzögerungsanordnung dient daher nicht vorwiegend der Verzögerung, sondern dazu, die Bildsignale in gleicher Weise zu behandeln wie die andere Verzögerungsanordnung, so daß gleiche Amplitudenfehler etc. entstehen.

In dem Beispielsfalle des PAL-Bildsignals entsteht das Problem, daß einerseits die Verzögerungsanordnungen nur so ausgeführt werden können, daß sie in beiden Reihen die gleiche Anzahl von Speicherelementen aufweisen. Andererseits soll der Ein- und Auslesevorgang mit Taktimpulsen einer bestimmten Taktperiode erfolgen.

Hierfür kann es gegebenenfalls erforderlich sein, eine ungeradzahlige Anzahl von Speicherelementen tatsächlich für die Verzögerung einzusetzen. In dem oben angeführten Beispielsfalle des PAL-Bildsignals wären dies 1135 Speicherelemente. Dies würde jedoch bedeuten, daß entweder in den beiden Speicherreihen eine ungleiche Anzahl von Speicherlementen vorgesehen sein müßte, was technologisch nicht möglich ist, oder das Taktsignal bezüglich seiner Frequenz entsprechend angepaßt werden müßte, was nicht wüschenswert ist.

Es wird daher ein zweites Taktsignal mit 1134 Taktimpulsen pro Zyklus erzeugt.

Dies wird anhand der ausschnittsweisen zeitlichen Darstellung der Fig. 2 im folgenden näher erläutert.

Dasjenige Taktsignal, das die gewünschte Frequenz aufweist, ist das erste Taktsignal, das in beiden Figuren mit clock1 gekennzeichnet ist. Dieses Taktsignal weist während einer wählbaren oder vorgegebenen Periode, beispielsweise während der Dauer einer Bildzeile eines Bildsignals, eine vorgegebene Anzahl von Taktimpulsen auf, welche die gewünschte Periodendauer aufweisen.

In der Darstellung gemäß Fig. 1 wird dieses der Takterzeugungsanordnung 9 zugeführt, welche hieraus das zweite Taktsignal clock2 formt. Die ausschnittsweise. Darstellung gemäß Fig. 2 zeigt, daß das zweite Taktsignal im wesentlichen dem ersten entspricht, daß jedoch in dem in Fig. 2 dargestellten zeitlichen Ausschnitt ein Impuls weggelassen wird. Bei der Erzeugung des zweiten Taktsignals wird in einem vorgegebenen Zyklus bestimmter Dauer ein Impuls des ersten Taktsignals unterdrückt. Hieraus wird das zweite Taktsignal clock2 generiert, mit dem nach Aufbereitung die beiden Verzögerungsanordnungen 2 und 3 der Anordnung gemäß Fig. 1 getaktet werden.

Durch diese Art der Erzeugung des zweiten Taktsignals kann die Anforderung erfüllt werden, eine Verzögerungszeit entsprechend einem ungeradzahligen Vielfachen der Periodendauer zu erzielen und dennoch eine geradzahlige Anzahl von Speicherelementen in den Verzögerungsanordnungen 2 und 3 anzusprechen, d.h. in diese Daten einzulesen oder aus diesen Daten auszulesen. Dennoch weist das zweite Taktsignal, abgesehen von der Lücke, eine Frequenz bzw. eine Takteriode mit der gewünschten Dauer auf.

Während des Auftretens der Lücke in dem zweiten Taktsignal können in die Verzögerungsanordnungen 2 und 3 keine Signale eingelesen bzw. aus diesen ausgelesen werden. Daher wird der Verzögerungsanordnung 9 gemäß Fig. 1 ein Schaltsignal SW zugeführt, welches beispielsweise bei der Verarbeitung eines Bildsignals während der Blanking-Zeiten zu Beginn jeder Bildzeile auftritt, in denen kein Bildinhalt übertragen wird. Damit wird erreicht, daß durch den "fehlenden" Impuls im zweiten Taktsignal kein Bildinhalt beeinträchtigt wird.

Durch die Erfindung wird im Ergebnis erreicht, daß in Verzögerungsanordnungen, deren Speicherelemente in zwei Reihen aufgebaut sind, ein beliebige Anzahl von Speicherelementen, insbesondere auch eine ungerade Anzahl, angesprochen werden kann. Es wird damit möglich, gewünschte, ideale Verzögerungszeiten einzustellen.

## Patentansprüche

1. Verzögerungsanordnung, welche Speicherelemente aufweist, welche in einer integrierten Schaltung in wenigstens zwei Reihen (4,5; 6,7), vorzugsweise in Switched-Capacitor-Technik, aufgebaut sind, dadurch gekennzeichnet,
daß die Verzögerungsanordnung (2; 3) eine geradzahlige Anzahl von Speicherelementen aufweist und daß ein erstes Taktsignal vorgesehen ist, aus welchem zur Erzeugung einer Verzögerungszeit eines ungeradzahligen Vielfachen der Taktperiode des ersten Taktsignals mittels einer Takterzeugungsanordnung (9) ein zweites Taktsignal generiert wird, mittels welchem die Speicherelemente getaktet werden und welches in der Weise aus dem ersten Taktsignal generiert wird, daß in einem wählbaren oder vorgegebenen Zyklus ein Taktimpuls des ersten Taktsignals unterdrückt wird und alle übrigen Taktimpulse in dem Zyklus in das zweite Taktsignal übernommen werden.

2. Verzögerungsanordnung nach Anspruch 1, dadurch gekennzeichnet,
daß der Verzögerungsanordnung (2; 3) ein Bildsignal zugeführt wird und daß in die Takterzeugungsanordnung (9) während solcher Zeiten bei der Erzeugung des zweiten Taktsignals einen Taktimpuls aus dem ersten Taktsignal unterdrückt, in denen in dem Bildsignal kein Bildinhalt übertragen wird, vorzugsweise während Blanking-Zeiten zu Beginn der Bildzeilen des Bildsignals.

3. Filteranordnung mit wenigstens zwei Verögerungsanordnungen (2,3) nach Anspruch 1 oder 2, dadurch gekennzeichnet,
daß für beide Verzögerungsanordnungen (2,3) eine gemeinsame Takterzeugungsanordnung (9) vorgesehen ist, welche das zweite Taktsignal liefert, mit dem die Speicherlemente in beiden Verzögerungsanordnungen (2,3) getaktet werden.

4. Kammfilteranordnung mit zwei Verzögerungselementen gemäß Anspruch 3.

5. Kammfilteranordnung nach Anspruch 4, dadurch gekennzeichnet,
daß die Takterzeugunganordnung (9) zur Filterung des Chroma-Signals eines Bildsignals der PAL-Norm in einem Zyklus von 1135 Taktimpulsen des ersten Taktsignals bei der Erzeugung des zweiten Taktsignals einen Taktimpuls zu Beginn jeder Bildzeile unterdrückt.

6. Rauschunterdrückungsanordnung mit zwei Verzögerungselementen nach Anspruch 3.
